Europäisches Patentamt

European Patent Office

Office européen des brevets

(11) Publication number: **0 519 187 A1**

# EUROPEAN PATENT APPLICATION

(21) Application number: **92107267.4**

(22) Date of filing: **29.04.92**

(51) Int. Cl.⁵: **H05K 5/00, H01B 17/18**

(30) Priority: **20.06.91 IT MI911689**

(43) Date of publication of application:
**23.12.92 Bulletin 92/52**

(84) Designated Contracting States:
**CH DE ES FR GB LI PT SE**

(71) Applicant: **ELCOM S.R.L.**
**Piazza Zaninelli, 6**
**I-20075 Lodi (Milano)(IT)**

(72) Inventor: **Negri, Virginio**
**Via Defendente, 34**
**I-20075 Lodi (Milano)(IT)**
Inventor: **Franzoni, Marco**
**Via F. Nullo, 18**
**I-20129 Milano(IT)**

(74) Representative: **Dr. Ing. A. Racheli & C. S.r.l.**
**Viale San Michele del Carso, 4**
**I-20144 Milano(IT)**

(54) **Sectional bar holder for electric panels.**

⑤ A sectional bar holder for allowing the passage of bars (2) in separator bulkheads (3) between two compartments of an electric panel, comprising two head elements (4), which are equal to one another, and possibly one or more intermediate elements (5), these also being equal to one another, according to the number of bars per phase, the elements (4, 5) being provided with fixed coupling means (8, 9; 8', 9'), in the form of grooves and complementary projections, which are able to be coupled reciprocally with each other, ribs (10', 10'') being foreseen on the perimeter of such elements which determine , after assembly, a perimetral molding (10), the whole unit being held together by springs (14) which prevent it slipping out of the bulkhead (3).

FIG.1

EP 0 519 187 A1

The aim of the present invention refers to a sectional bar holder far electric panels, which is suitable in particular for allowing the support and passage of conductor bars from one compartment of an electric panel to the other.

As is already known, there is foreseen in an electric panel a control part which is not live, separated by a metallic partition from a distribution part, which is live. The two compartments are connected to each other by conductor bars, which obviously must pass through the separator partition, and which must be insulated with respect to it.

The conductor bars are rectangular in section, and their number depends on the type of installation (the number of phases, plus a possible neutral, and the number of bars in parallel per phase).

In order to achieve the passage of these conductor bars through the separator partition of the compartments of an electric panel, at present insulating plates are used, which are previously machined on the basis of the number of bars to be housed, and which are then positioned in a large window made in the wall, whose dimensions are such as will contain all the bars side by side.

A serious drawback with this technique lies in the fact that the insulating plates must be planned beforehand, and it is not possible to adapt them on the spot. Another disadvantage is that it is necessary to drill a slot large enough to contain all the bars which must be placed side by side, which involves the possibility that the wall might be weakened.

The aim of the invention is to eliminate the drawbacks described above, by providing in particular a sectional bar holder, which will be easy to assemble and install on the spot, according to the number of bars which it must contain, by making a hole in the bulkhead for each phase, and of a size depending on the number of bars in parallel in each phase. The bar holder according to the invention substantially comprises two head elements, which are equal to one another, in the case of a single bar, and with an intermediate element, for separating the different bars from one another, in the case of two or more bars. All the intermediate elements are equal to one another.

Therefore the elements which make up the bar holder according to the invention are brought down to one head element, or head, and an intermediate element, or spacer.

With only two such elements it is possible to obtain all the possible combinations For example, by joining the two heads together the passage for a single bar is obtained, while by the interposition of one or more spacers between such heads the passage for an equivalent number of additional bars is obtained.

The head element has, near the end of one of its sides, which is located towards the inside after the bar holder has been formed, a transverse groove and a projection or tongue respectively, which are perfectly complementary to each other. In such a way, two head elements, positioned opposite each other and one upside down with respect to the other, fit tightly into each other reciprocally, thus determining a rectangular seating for the passage of a bar.

Each intermediate or spacer element has, however, at the ends of each of its sides, a groove and a projection, which are opposite to a projection and a groove foreseen on the other side. In such a way, each intermediate element is able to be coupled with an equal element or with a head element, and in this way any composition whatsoever can be obtained.

Both the head elements and the intermediate elements have raised sections on their periphery which make up a molding when the bar holder has been assembled, which is suitable for forming a stop against the housing bulkhead.

All the different elements are then held together by two special springs, which are housed in cavities made in such elements and which act also as transverse locking elements of the bar holder. Further characteristics of the invention will be more clearly understood from the detailed description which follows, with reference to one of its purely exemplary embodiments, and therefore not restrictive, which is illustrated in the appended drawings, in which:

figure 1 is a partially exploded, perspective view of a bar holder according to the invention, for housing four bars;

figure 2 is a view from the back of figure 1, with some parts in section, of the bar holder according to the present invention, in the working condition;

figure 3 is a section taken along the line III-III in figure 2;

figures 4 and 5 are respectively a front view and side profile view of the intermediate element of the sectional bar holder, according to the present invention.

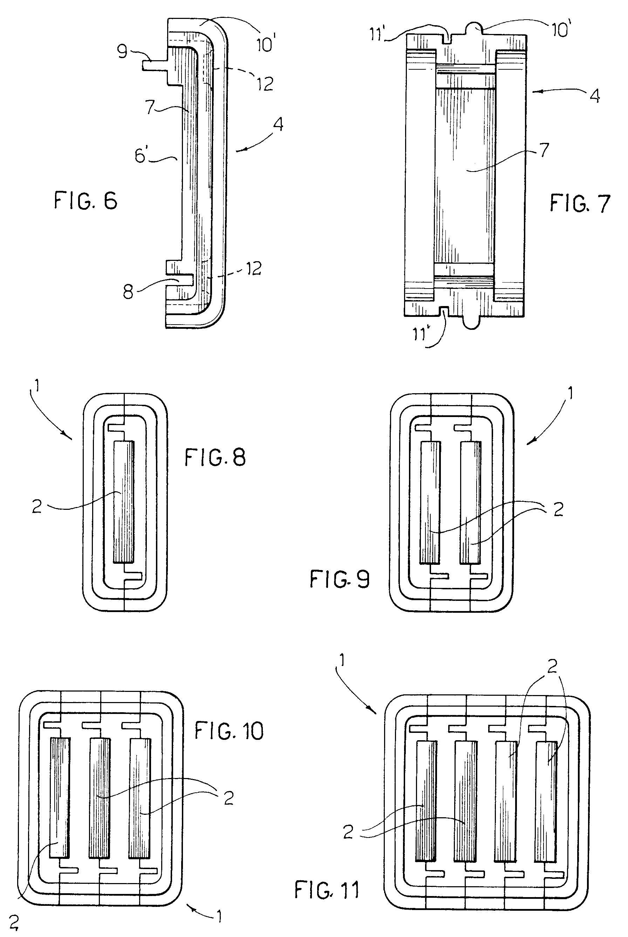

figures 6 and 7 are a front view and a side profile view of the head element;

figures 8, 9, 10 and 11 show a diagrammatic front view of the bar holder according to the present invention, for the passage of one, two, three and four bars respectively.

With reference to such figures, with number 1 the sectional bar holder as a whole according to the invention is indicated, which is illustrated in the figures from 8 to 11 respectively for one, two, three and four bars, 2 per phase, according to the electric installation.

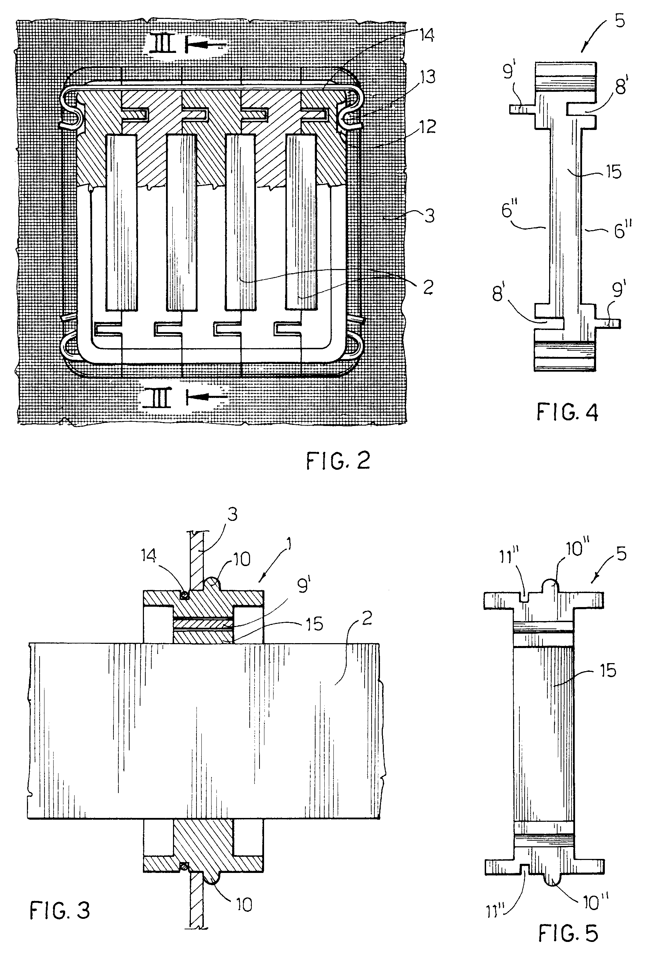

The bar holder 1 is obviously made from insulating material, preferably polyester- glass, as the conductor bars 2 must be insulated from the separator bulkhead 3 (see figures 2 and 3) of the two compartments of an electric panelboard.

The bar holder 1 is obtained by the appropriate combination of a head element 4 and an intermediate element 5.

The head element 4 has a "semi-rectangular " profile, with rounded outer edges and an open inner cavity 6', suitable for determining with an equal cavity a rectangular seating for the passage of a bar 2.

At the two ends of the cavity 6', which is made in a raised central part 7 of the head element 4, are foreseen respectively a groove 8, which is transversal ( in the direction of the depth of the element 4) and a corresponding projection or tongue 9, which is perfectly complementary to the groove 8, in such a way that the two head elements 4, which are positioned opposite to one another, one of them being upside down with respect to the other, can fix into each other tightly, thus determining a rectangular opening 6 for the passage of a bar 2, as is illustrated in figure 8.

A continuous outer rib 10' is also foreseen on the element 4, as well as a groove 11' on its upper and lower sides, which is parallel to and at a certain distance from the rib 10', in such a way that the bar holder 3 can be positioned between them, as will be described more clearly below. In alignment with the said grooves 11', on the outer side of the head element 4, and near its ends, respective recesses 12 are foreseen, which serve to house the ends, which are bent inwards, of a "wire-type" spring, which is housed in the groove 11', as will be described more clearly below.

The intermediate element or spacer 5 has two opposite side cavities 6'', which are completely identical with the cavities 6' of the head element 4 and which delimit a central body 15, of a thickness equal to the width of the said cavity 6 which is determined by the coupling of two cavities 6', two cavities 6'', or one cavity 6' and one cavity 6''.

On each side of the element 5, near to its ends, a groove 8' and a projection 9' are foreseen, with a projection 9' and a groove 8' being opposite to them on the opposite side. The grooves 8' and the projections 9' are perfectly complementary to each other, and they are equal to the groove 8 and to the projection 9 of the head element 4.

Ribs 10'' and grooves 11'' are foreseen on the upper and lower sides of the element 5, in perfect alignment with the corresponding ribs 10' and grooves 11', which are foreseen on the head elements 4, in such a way as to determine respectively a peripheral molding 10 and two opposite longitudinal grooves 11 in the composition of a bar holder.

From what has been described above, the assembly and mounting of the bar holder according to the present invention is very easy.

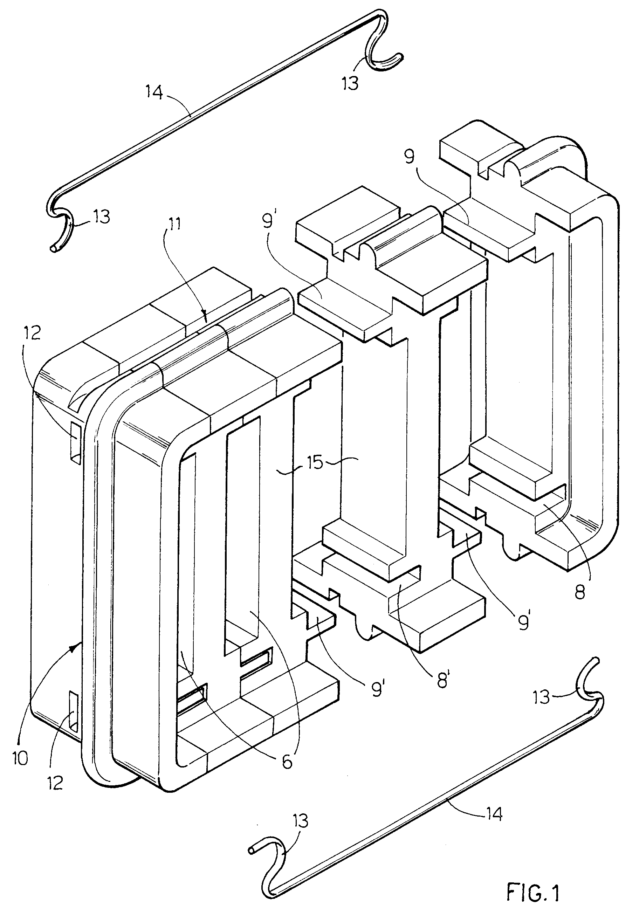

Two head elements 4 are still used and one or more intermediate elements 5, according to the number of bars in parallel per phase which have to be passed through. For example, in the figures 1 and 2, a bar holder is illustrated, which has three intermediate elements 5 for the passage of four bars.

The grooves 8, 8' and the projections 9, 9' are reciprocally fixed coupled with each other, to make up the bar holder 1, which is inserted into a hole made in the bulkhead 3, which has dimensions which correspond to its outer profile.

After mounting, the said perimetral molding 10 moves to abut against one face of the bulkhead 3, while the springs 14, as well as holding the whole unit of the elements 4 and 5 together, act with their ends against the other face of the bulkhead 3, thus preventing the bar holder 1 from slipping out by accident.

The sturdiness of the construction of the head elements 4 and of the intermediate elements 5 guarantees a high level of mechanical sealing of the bars in the event of a short circuit.

It is obvious that the elements 4 and 5 are sized on the basis of the standard dimensions of the bars which are to be supported.

**Claims**

1. A bar holder for electric panels, suitable for allowing the passage of one or more bars (2) through a separator bulkhead (3) between two compartments, characterized in that it comprises two head elements (4) and at least one possible intermediate element (5), shaped in such a way as to determine, by their coupling, rectangular seatings (6) for the passage of the bars (2), said elements (4, 5) being provided with fixed coupling means (8, 9; 8', 9'), and means (14) being foreseen for holding said elements (4, 5) together when the composition has been completed.

2. A bar holder according to claim 1, characterized in that the two head elements (4) are equal to one another, just as the intermediate elements (5) are equal to each other, said fixed coupling means consisting of grooves (8, 8') which are equal to one another and made respectively in the head elements (4) and in the intermediate elements (5), and of corresponding projections (9, 9'), these too being equal to one another and foreseen respectively in the elements (4) and (5).

3. A bar holder according to claim 2, in which the said groove (8) and the said projection (9) are made near the ends of the inside face of the head element (4), while the corresponding grooves (8') and projections (9') of the intermediate element (5) are symmetrically positioned near the ends of both its side faces.

4. A bar holder according to any one of the previous claims, characterized in that on the outer profile of said head elements (4) a continuous or discontinuous rib (10') is foreseen, while on the upper and lower side of the intermediate elements (5) a respective rib (10'') is foreseen, which is such that, after the assembly of the bar holder, a perimetral molding (10) is obtained which abuts against the bulkhead (3), when the bar holder is inserted in a suitable hole made in the latter.

5. A bar holder according to any one of the previous claims, characterized in that respective grooves (11') are made on the upper and lower faces of the head elements (4), and similar grooves (11'') are made on the corresponding faces of the intermediate elements (5), in such a way as to obtain, after assembly, continuous grooves (11) which are suitable for housing the said fastening means (14), which consist of a rod-shaped spring, whose ends (13) are bent inwards and housed in corresponding recesses (12) made on the outer wall of the said head elements (4).

6. A bar holder according to claim 5, characterized in that said springs (14), being positioned parallel to and at a distance from the said perimetral molding (10), constitute a stop element for the unit, after it has been positioned in the bulkhead (3).

7. A bar holder according to any one of the previous claims, characterized in that it is made of polyester glass or polyester resins.

FIG.1

FIG. 2

FIG. 4

FIG. 3

FIG. 5

FIG. 6

FIG. 7

FIG. 8

FIG. 9

FIG. 10

FIG. 11

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y<br>A | DE-B-2 557 960 (SIEMENS)<br><br>* column 2, line 10 - line 19 *<br>* column 2, line 47 - column 4, line 9 *<br>* figures 1-4 *<br>--- | 1<br>2 | H05K5/00<br>H01B17/18 |
| Y | FR-A-2 579 006 (CGEE ALSTHOM)<br>* page 2, line 3 - line 10; figures 1,2 *<br>--- | 1 | |
| A | US-A-4 766 519 (B.HEILAND)<br>* column 2, line 44 - line 54; figure 2 *<br><br>----- | 1 | |

**TECHNICAL FIELDS SEARCHED (Int. Cl.5 )**

H05K
H01B
H02B

The present search report has been drawn up for all claims

| Place of search | Date of completion of the search | Examiner |
|---|---|---|
| BERLIN | 03 SEPTEMBER 1992 | ALEXATOS G. |